# EUROPÄISCHE PATENTSCHRIFT

(11) **EP 3 368 705 B1**
(45) Veröffentlichungstag und Bekanntmachung des Hinweises auf die Patenterteilung: **02.03.2022**
(21) Anmeldenummer: 16797448.4
(22) Anmeldetag: 20.10.2016
(51) Int. Cl.: C23C 14/56

(54) **VORRICHTUNG UND VERFAHREN ZUM BESCHICHTEN ÜBERLANGER FLÄCHENHAFTER SUBSTRATE, INSBESONDERE GLASSCHEIBEN, IN EINER VAKUUM-BESCHICHTUNGSANLAGE**
DEVICE AND METHOD FOR COATING EXTRA-LONG SHEET-TYPE SUBSTRATES, IN PARTICULAR GLASS PANES, IN A VACUUM COATING SYSTEM
DISPOSITIF ET PROCÉDÉ DE REVÊTEMENT DE SUBSTRATS DE TYPE PLATS ALLONGÉS, NOTAMMENT PLAQUES DE VERRE, DANS UNE INSTALLATION DE REVÊTEMENT SOUS VIDE

(30) Priorität: 26.10.2015 DE 102015013799
(43) Veröffentlichungstag der Anmeldung: 05.09.2018
(73) Patentinhaber: Grenzebach Maschinenbau GmbH, 86663 Asbach-Baeumenheim (DE)
(72) Erfinder: GAWER, Olaf, 01328 Dresden (DE); RICHERT, Holger, 63486 Bruchköbel (DE); ELLRICH, Jens, 86685 Huisheim (DE)
(74) Vertreter: Kindermann, Peter
(86) Internationale Anmeldenummer: PCT/DE2016/000376
(87) Internationale Veröffentlichungsnummer: WO 2017/071677

(56) Entgegenhaltungen:
- WO-A1-2009/004048
- DE-A1- 10 348 639
- DE-A1- 19 857 201
- DE-A1-102012 202 715
- DE-C1- 19 808 163

## Beschreibung

Die Erfindung betrifft eine Vorrichtung und ein Verfahren zum Beschichten überlanger flächenhafter Substrate, insbesondere Glasscheiben, in einer Vakuum-Beschichtungsanlage.

Die magnetfeldunterstützte Kathodenzerstäubung (Magnetron Sputtering) hat Eingang gefunden in viele Bereichen der modernen Oberflächentechnik.

Ausgehend von Anwendungen in der Halbleiterelektronik ist die magnetfeldunterstützte Kathodenzerstäubung heute als industrielles Beschichtungsverfahren für Architekturglas, Flachbildschirme, Brillengläser, Bandmaterialien, Werkzeug, dekorative Gegenstände und funktionelle Bauteile etabliert.

Die größten Vakuum-Beschichtungsanlagen, und damit oftmals auch die Anlagen mit dem höchsten Energiebedarf, sind die typischen horizontalen In-Line-Anlagen für die Architekturglas-Beschichtung.

Im Laufe der Entwicklung haben sich Standardscheibenformate sowohl für die Beschichtung als auch für die weitere Verarbeitung und Logistik etabliert. Die Beschichtungsanlagen werden in der Regel für die Standardscheibenformate (z.B. Länge 6,00 m x Breite 3,21 m) ausgelegt.

Zusätzlich werden in den Beschichtungsanlagen übergroße Scheibenformate beschichtet. Der prozentuale Anteil diese übergroßen Scheibenformate am gesamten Produktionsvolumen ist eher gering, so das mittels technischer und steuerungstechnischer Anpassungen der Anlage Möglichkeiten geschaffen werden, auch überlange Scheibenformate (z.B. Länge 12,00 m × Breite 3,21 m) ohne nennenswerte Investitionen zu beschichten.

Gemäß dem Stand der Technik werden spezifische Anordnungen von Vakuumpumpen bzw. Vakuumpumpständen und auch Strömungsblenden innerhalb von Vakuumkammern benutzt, um eine Beschichtungsanlage sowohl für Standardscheiben als auch für überlange Scheibenformate benutzen.

Aus dem Stand der Technik wird auf die folgenden Druckschriften verwiesen: In der EP 1 571 234 B1 wird ein Verfahren für den Betrieb einer Inline-Beschichtungsanlage beschrieben.

Um flächenhafte Substrate, insbesondere Glasscheiben, zu beschichten, werden in der Beschichtungsanlage Substrate unter Vakuumbedingungen beschichtet, wobei sich vom Target abgetragenes Material auf dem betreffenden Substrat niederschlägt. Dem hier vorgestellten Verfahren liegt die Zielsetzung zugrunde, mit nur einer Beschichtungsanlage sowohl normale Substrate als auch Substrate mit Überlänge beschichten zu können.

Bei diesem Verfahren wird im Oberbegriff des Patentanspruchs 1 folgender Stand der Technik behandelt. Hierbei wird von einem Verfahren für den Betrieb einer Inline-Beschichtungsanlage mit einer Einschleuskammer, einer daran anschließenden Pufferkammer, einer daran anschließenden Prozesskammer, einer weiter daran anschließenden Pufferkammer und einer hieran anschließenden Ausschleuskammer ausgegangen. Bei diesem Verfahren sind zwischen den Kammern Tore vorgesehen, die geöffnet und geschlossen werden können, wobei die Einschleuskammer, die Pufferkammer und die Ausschleuskammer als gleichartige Module und für die Aufnahme von Substraten bis zu einer vorgegebenen Maximalgröße vorgegeben sind.

Die Druckschrift DE 198 08 163 C1 offenbart ein Schleusensystem für eine Vakuumbeschichtungsanlage, welche eine Schleusenkammer, eine Überführungskammer und eine Prozesskammer aufweist. Das Transportsystem basiert hierbei auf Rollen, wobei im Bereich der Überführungskammer ferner mehrere Pumpen und ferner in der Höhe einstellbare Strömungsleitelemente vorgesehen sind, um Puffersektionen innerhalb der Überführungskammer auszubilden.

Ferner ist aus der Druckschrift DE 198 57 201 A1 eine Vakuumanordnung mit mehreren Vakuumkammern bekannt, wobei zwischen zwei Vakuumkammern zur Verringerung des Gasaustausches ein Schleusenventil angebracht ist. Das Schleusenventil besitzt hierbei ein Schiebergehäuse, in dem ein Schieber zum Öffnen und Schließen des Schleusenventils vertikal verschoben wird.

Die Druckschrift WO 2009/004048 A1 behandelt ein Verfahren und eine Vorrichtung zum Schleusen überlanger Substrate in einer Vakuumbeschichtungsanlage.

Üblicherweise kommen bei solchen Verfahren Drei-Kammer-Vakuumbeschichtungsanlagen oder Fünf-Kammer-Beschichtungsanlagen zum Einsatz. Im Unterschied zur Fünf-Kammer-Beschichtungsanlage besitzt die Drei-Kammer-Beschichtungsanlage keine Pufferkammer.

In dieser Druckschrift ist zwar konkret keine Zielsetzung angegeben, jedoch lässt sich der Beschreibung insbesondere auf der Seite 5, oben, entnehmen, dass neben der im Titel angegebenen Verwendung dieses Verfahrens zur Beschichtung überlanger Substrate mittels einer Druckentkopplung innerhalb eines Schleusensystems die Pumpzeiten für das Schleusensystem und somit die Taktzeiten der Anlage im Vergleich zum Betrieb als Dreikammeranlage verringert werden.

Im Patentanspruch 1 der WO 2009/004048 A1 wird ein Verfahren zum Einschleusen eines Substrats in eine oder aus einer Vakuumbeschichtungsanlage beansprucht, wobei in dieser Anlage an eine Schleusenkammer eine Pufferkammer und daran ein Prozessbereich angrenzt, die Schleusenkammer und Pufferkammer voneinander durch jeweils ein schließbares Zwischentor zu trennen sind und die Schleusenkammer ein erstes Pumpsystem sowie die Pufferkammer ein zweites Pumpsystem umfassen, mit den folgenden Verfahrensschritten:
a) Transportieren des Substrats durch ein geöffnetes, vakuumdicht schließbares eingangsseitiges Tor in eine verlängerte Schleusenkammer, gebildet aus Schleusenkammer und Pufferkammer bei geöffnetem Zwischentor, wobei ein die verlängerte Schleusenkammer ausgangsseitig abschließendes Tor vakuumdicht verschlossen ist,
b) Schließen des eingangsseitigen Tores und Einstellen von Druckverhältnissen in der verlängerten Schleusenkammer mit einer Druckdifferenz zwischen Schleusenkammer und Pufferkammer mit geringerem Druck in der Pufferkammer unter Verwendung eines Strömungswiderstandes, welcher in der verlängerten Schleusenkammer angeordnet ist, und
c) Öffnen des ausgangsseitigen Tores und Transportieren des Substrats aus der verlängerten Schleusenkammer.

Nachteilig bei der in der WO 2009/004048 A1 beschriebenen Vakuumbeschichtungsanlage ist, dass ein erstes Pumpsystem in der Schleusenkammer und ein zweites Pumpsystem in der Pufferkammer, jeweils bestehend aus vielen Pumpen, notwendig ist. In der Regel wird dabei das gesamte Volumen gebildet aus der Schleusenkammer und der Pufferkammer zuerst vom Pumpsystem der Schleusenkammer auf einen Druck von p< 20 mbar evakuiert.

Dann übernimmt das Pumpsystem der Pufferkammer und evakuiert das Volumen weiter bis auf einen Druck p< 0,02 mbar.

Der Erfindung liegt daher die Aufgabe zugrunde, eine Vorrichtung und ein Verfahren zum Beschichten überlanger flächenhafter Substrate zu schaffen, wobei bei verringerter Anzahl von Pumpen die Produktivität erhalten bleibt und die Zuverlässigkeit und Sicherheit der Anlage erhöht wird.

Erfindungsgemäß wird diese Aufgabe hinsichtlich der Vorrichtung durch die Merkmale des Patentanspruchs 1 und hinsichtlich des Verfahrens durch die Maßnahmen des Patentanspruchs 4 gelöst.

In den Unteransprüchen sind weitere vorteilhafte Ausgestaltungen der Erfindung gekennzeichnet.

Die erfindungsgemäße Vorrichtung wird im Folgenden näher beschrieben.

Es zeigen im Einzelnen:
Fig. 1: eine erfindungsgemäße Vorrichtung im Längsschnitt,
Fig. 2: einen Querschnitt aus dem Eingangsbereich der erfindungsgemäßen Vakuum-Beschichtungsanlage,
Fig. 3: einen Querschnitt aus dem Bereich der Pufferkammer, und
Fig. 4: die Ausgestaltung eines Adapterflansches.

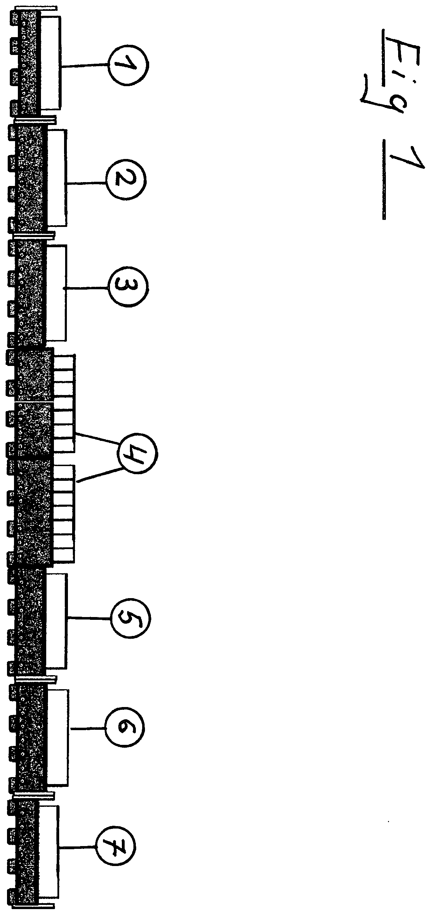

Die Fig. 1: zeigt eine erfindungsgemäße Vorrichtung im Längsschnitt.

Die gesamte Vakuum-Beschichtungsanlage besteht in der Durchlaufrichtung aus einer eingangsseitigen Schleusenkammer 1, in die das zu beschichtende Substrat aus dem Bereich der normalen Atmosphäre eintritt, einer folgenden Pufferkammer 2 und einer, auf diese beiden Kammern folgenden, Transferkammer 3. Im weiteren Verlauf des Beschichtungsprozesses gelangt das Substrat in den Bereich der beiden Prozesskammern 4, in denen der eigentliche Prozess der Beschichtung stattfindet. Nach der erfolgten Beschichtung wird das Substrat wieder, umgekehrt wie im Bereich der eingangsseitigen Kammern 1, 2 und 3, über die ausgangsseitige Transferkammer 5 in die ausgangsseitige Pufferkammer 6 und dann in die ausgangsseitige Schleusenkammer 7 geführt. Bei dem Austritt aus der ausgangsseitigen Schleusenkammer 7 gelangt das beschichtete Substrat wieder in den Bereich der normalen Atmosphäre.

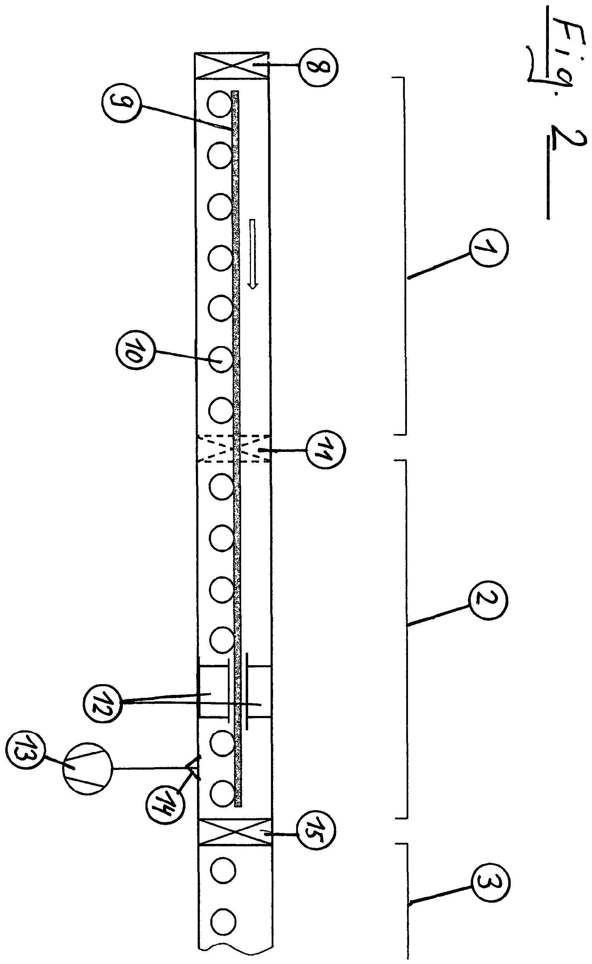

Die Fig. 2: zeigt einen Querschnitt aus dem Eingangsbereich der erfindungsgemäßen Vakuum-Beschichtungsanlage, wobei die Bereiche der Schleusenkammer 1, der folgenden Pufferkammer 2 und eines Teils der weiterhin folgenden Transferkammer
3 im oberen Teil der Fig.2 mittels entsprechend gekennzeichneten Bereichsgrenzen markiert sind.

Hier ist eine Substratplatte 9 im Querschnitt auf einer Transportvorrichtung 10 zu erkennen, wobei die Transportvorrichtung 10 im Querschnitt mittels kreisförmig dargestellten Laufrollen symbolisiert ist und die Substratplatte 9 den, den Eingangsbereich der Vakuum - Beschichtungsanlage vakuumdicht von der normalen Atmosphäre abschließenden, Bereich hinter sich hat .Dieser Eingangsbereich wird von der normalen Atmosphäre mittels des eingangsseitigen Klappenventils 8 der Schleusenkammer 1 gebildet. Die gesamte Länge der Substratplatte 9 ist in diesem gezeigten Beispiel als überlang zu erkennen, denn sie reicht in der Läge vom Beginn der Schleusenkammer 1 über deren gesamte Länge bis fast zum Ende der anschließenden Pufferkammer 2. Die Richtung der Bewegung der Substratplatte 9 ist hierbei mittels eines Pfeils in der Schleusenkammer 1 gekennzeichnet. Das am Beginn der Pufferkammer 2 vorgesehene Klappenventil 11 ist in der Fig.2 gestrichelt, und damit als geöffnet, dargestellt, denn die Überlänge der Substratplatte 9 erfordert eine Öffnung dieses Klappenventils 11.

Im Bereich der Pufferkammer 2 sind Strömungsblenden 12 symbolisch als zwei Linien dargestellt die parallel zu Teilbereichen der beiden Oberflächen der Substratplatte 9 verlaufen wobei deren Abstand zu diesen beiden Oberflächen variabel einstellbar ist.

Eine Strömungsblende verringert den offenen Querschnitt um die, durch die Vakuum - Beschichtungsanlage zu transportierende, Substratplatte derart, dass in den angrenzenden Kammerbereichen in Abhängigkeit von den Druckverhältnissen ein Gasaustausch erschwert wird und somit ein Druckausgleich verhindert wird. Je nach der Lage einer oder mehrerer Strömungsblenden können verschieden hohe Druckdifferenzen mit einer oder mehr Abstufungen des Drucks innerhalb eines Schleusensystems erzeugt werden. Eine solche Strömungsblende bewirkt, dass, bei der Beschichtung einer überlangen Substratplatte 9, im Bereich der durch ein offenes Klappenventil 11 verbundenen Schleusenkammer 1 und einer Pufferkammer 2 eine Druckdifferenz erzeugt wird die den Druckverhältnissen entspricht wie sie bei geschlossenem Klappenventil 11 herrschen.

Weiter sind im Bereich der Pufferkammer 2 ein Adapterflansch 14 für den Betrieb einer Hochleistungs - Vakuumpumpe 13 und das eingangsseitige Klappenventil 15 der Transferkammer dargestellt.

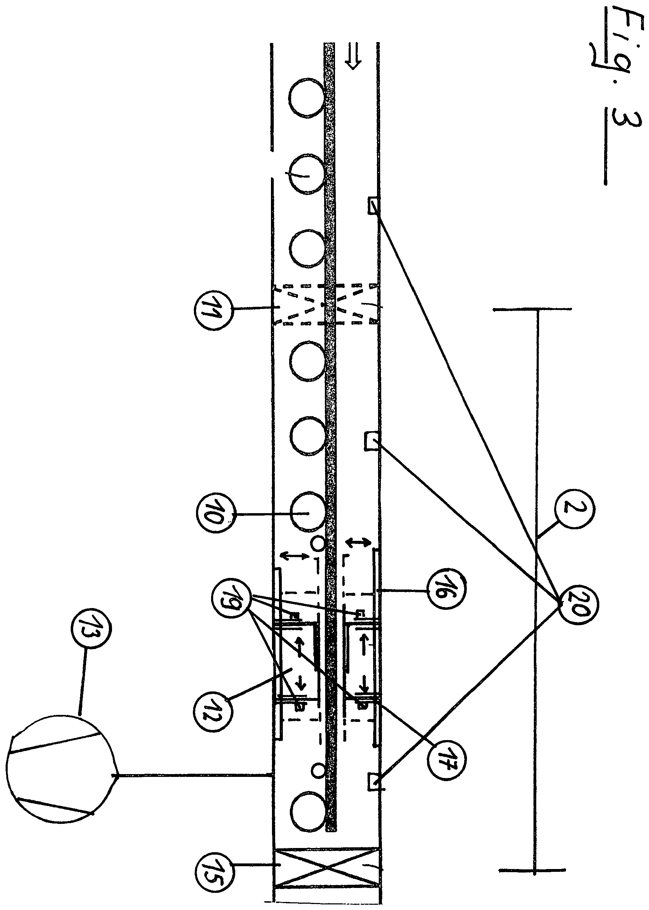

Die Fig.3: zeigteinen Querschnitt aus dem Bereich der Pufferkammer.

Hier sind besonders die Verhältnisse um die Strömungsblenden 12 detaillierter dargestellt. Wie schon bei der Beschreibung der Fig.2 bemerkt, sind die Abstände der Strömungsblenden 12 zu den beiden Oberflächen der zu beschichtenden Substratplatte 9 variabel ausgestattet, was durch eine Einrichtung 17 zur Höhenverstellung der Strömungsblenden 12 bewirkt wird. Dies dient zum einen der Anpassung der Strömungsblenden 12 an die Dicke der jeweiligen Substratplatte 9. Zum anderen beeinflusst der Abstand der beiden Strömungsblenden 12 zu den beiden Oberflächen der Substratplatte 9 die durch die Anordnung der Strömungsblenden 12 hervorgerufene Druckdifferenz innerhalb des Schleusensystems. Demselben Zweck dient auch eine Einrichtung 16 die die Fläche der Strömungsblende 12 in horizontaler Richtung, also längsverschieblich parallel zu der Oberfläche der jeweiligen Substratplatte 9 vergrößert oder verkleinert. Als Mechanismus für eine solche Anordnung kann eine Blechfläche dienen die in einer eng anliegenden weiteren Blechtasche horizontal verschiebbar gestaltet ist. Als Antrieb für die vertikale und horizontale Verschiebbarkeit einer oder mehrerer Strömungsblenden 12 sind nicht näher bezeichnete Servomotoren vorgesehen. Die Steuerung dieser Servomotoren wird durch Sensoren 19 zur Abstandsmessung und der Längsverstellung der Strömungsblenden 12 unterstützt. Die konstruktive Ausgestaltung entsprechender Verstell - Mechanismen zur beschriebenen Verstellbarkeit der Strömungsblenden 12 sind einem Fachmann geläufig.

Zur weiteren steuerungstechnischen Kontrolle des gesamten Beschichtungsprozesses dienen die beispielhaft in der Fig.3 dargestellten Lichtfeldsensoren 20.

Hinsichtlich dieser verwendeten Lichtfeld - Sensoren 20, wird auf die Entwicklung der so genannten Minilinsen verwiesen, die in der Form von hunderten von Minilinsen nach dem Lichtfeldprinzip optische Informationen sammeln die dann später zu Bildern mit einer gewünschten Auflösung und / oder einem gewünschten Blickwinkel datentechnisch zusammengestellt werden können. Solche Minilinsen sind 3 - D - fähig, billig herzustellen und folgen dem Prinzip eines Insektenauges. Mit Hilfe dieser Lichtfeldsensoren 30 kann somit, neben der normalen Schwenkbarkeit, der gewünschte Blickwinkel und / oder die gewünschte Vergrößerung eines Bildausschnitts auf rein elektronischem Weg erreicht werden.

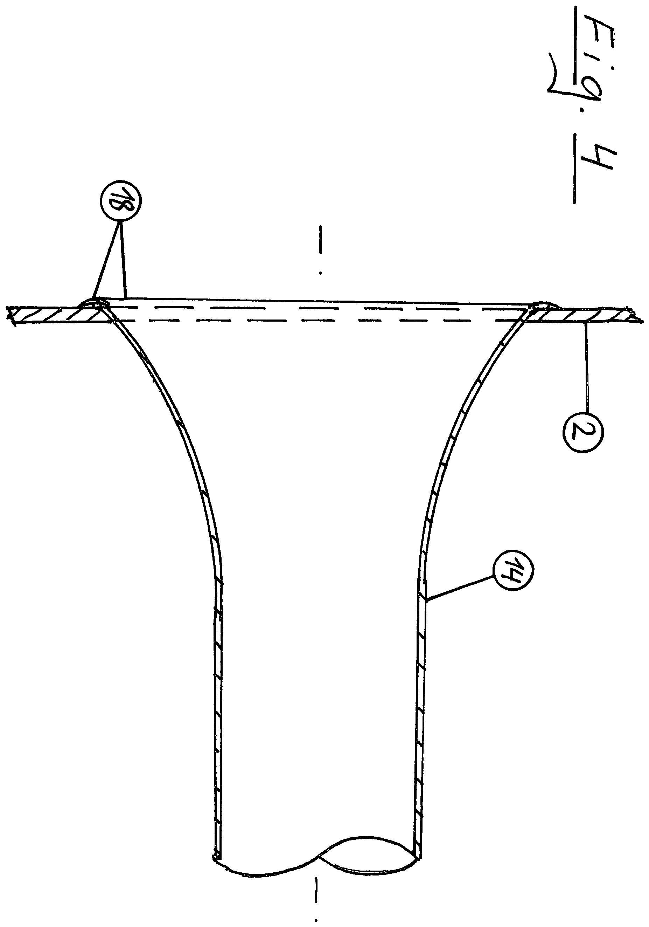

Die Fig.4: zeigt die Ausgestaltung eines Adapterflansches. Der aus der Beschreibung der Fig.2 bekannte Adapterflansch 14 ist mittels eines Anschlussrings 18 an der eingangsseitigen Pufferkammer 2 befestigt und weist einen Querschnitt auf der der Hochleistungs - Vakuumpumpe 13 einen geringen Strömungswiderstand entgegensetzt, bevorzugt ist hier an die Form eine hyperbolischen Zylinders gedacht. Als Hochleistungs - Vakuumpumpe 13 sind derzeit zweistufige Vakuumsysteme mit gegen Atmosphärendruck arbeitenden Vorpumpen und nachfolgenden Schrauben- oder Wälzkolbenpumpen im Einsatz, die über einen Arbeitsdruckbereich von1013 mbar bis 0,003 mbar aufweisen und dabei einen Ansaugvolumenstrom von 2700 bis 5700 m³/h, in einzelnen Fällen auch einen zusätzlichen dynamischen Volumenstrom von bis zu 20000 m³/h liefern können,

Die Anordnung zur Steuerung der Bewegungsvorgänge, insbesondere der Transportvorrichtung (10), der Betätigung der Klappenventile, der Verstellung der Strömungsblenden und der Betätigung der Hochleistungs - Vakuumpumpe ist nicht gesondert bezeichnet.

Die komplexe Steuerung der beschriebenen Bewegungsabläufe erfordert ein spezielles Steuerungsprogramm.

### Bezugszeichenliste

- 1: Bereich der eingangsseitigen Schleusenkammer
- 2: Bereich der eingangsseitigen Pufferkammer
- 3: Bereich der eingangsseitigen Transferkammer
- 4: Bereich der Prozesskammern
- 5: Bereich der ausgangsseitigen Transferkammer
- 6: Bereich der ausgangsseitigen Pufferkammer
- 7: Bereich der ausgangsseitigen Schleusenkammer
- 8: eingangsseitiges Klappenventil der Schleusenkammer
- 9: Substratplatte ( übergroße Abmessung )
- 10: Transportvorrichtung
- 11: eingangsseitiges Klappenventil der Pufferkammer
- 12: Strömungsblenden
- 13: Hochleistungs - Vakuumpumpe
- 14: Adapterflansch
- 15: eingangsseitiges Klappenventil der Transferkammer
- 16: Einrichtung zur Längsverschiebung der Strömungsblende
- 17: Einrichtung zur Höhenverstellung der Strömungsblende
- 18: Anschlussring für den Adapterflansch 14
- 19: Sensoren zur Abstandsmessung
- 20: Lichtfeldsensoren

## Patentansprüche

1. Vorrichtung zum Beschichten überlanger flächenhafter Substrate in einer Vakuum-Beschichtungsanlage, mit den folgenden Merkmalen:
a) einer Hintereinanderschaltung von eingangsseitig angeordneten, von der jeweiligen Substratplatte (9) zu durchlaufenden Kammern, nämlich einer Schleusenkammer (1), einer Pufferkammer (2) und einer Transferkammer (3), wobei jede dieser Kammern eingangsseitig mittels eines Klappenventils (8, 11, 15) luftdicht verschließbar ist und wobei der Transferkammer (3) ein Bereich von Prozesskammern (4) und den Prozesskammern (4) eine ausgangsseitige Hintereinanderschaltung einer Transferkammer (5), einer Pufferkammer (7) und einer Schleusenkammer (8) folgen,
b) einer auf Rollen aufgebauten Transportvorrichtung (10),
c) einer einzigen Hochleistungs-Vakuumpumpe (13) mit einem Adapterflansch (14) in dem Bereich der Pufferkammer (2),
d) mindestens einer Strömungsblende (12) in dem Bereich der Pufferkammer (2),
e) einer Einrichtung (16) zur Längsverschiebung der Strömungsblenden (12), wobei als Mechanismus eine Blechfläche dient, die in einer eng anliegenden weiteren Blechtasche horizontal verschiebbar gestaltet ist,
f) einer Einrichtung (17) zur Höhenverstellung der Strömungsblenden (12), und
f) einer Anordnung zur Steuerung der Bewegungsvorgänge.

2. Vorrichtung nach Anspruch 1, **dadurch gekennzeichnet, dass** Sensoren (19) zur Kontrolle der von der Einrichtung (16) zu Längsverschiebung der Strömungsblenden (12) und/oder der Einrichtung (17) zur Höhenverstellung der Strömungsblenden (12) vorgesehen sind.

3. Vorrichtung nach Anspruch 1 oder 2, **dadurch gekennzeichnet,**
**dass** zur steuerungstechnischen Kontrolle des gesamten Beschichtungsprozesses Lichtfeldsensoren (20) vorgesehen sind.

4. Verfahren zum Beschichten überlanger flächenhafter Substrate in einer Vakuum-Beschichtungsanlage, mit den folgenden Verfahrensschritten:
a) nach dem Öffnen eines eingangsseitigen Klappenventils (8) einer eingangsseitigen Scheusenkammer (1) wird die zu beschichtende Substratplatte (9) mittels einer Transportvorrichtung (10) in die Schleusenkammer (1) transportiert, wobei im Falle einer überlangen Substratplatte (9) gleichzeitig das eingangsseitige Klappenventil (11) einer, der Schleusenkammer (1) folgenden, Pufferkammer (2) geöffnet wird und wobei das eingangsseitige Klappenventil (15) einer folgenden Transferkammer (3) geschlossen ist,
b) nachdem die Substratplatte (9) den Bereich des Klappenventils (8) passiert hat, wird das Klappenventil (8) geschlossen,
c) dann erfolgen eine Längsverschiebung und eine Höhenverstellung der installierten Strömungsblenden (12) entsprechend den Abmessungen der Substratplatte (9) hinsichtlich deren Länge und Dicke mittels einer Einrichtung (16), wobei als Mechanismus eine Blechfläche dient, die in einer eng anliegenden weiteren Blechtasche horizontal verschiebbar gestaltet ist, und einer Einrichtung (17),
d) nach dem Betrieb einer Hochleistungs-Vakuumpumpe (13) wird die Substratplatte (9) in den Bereich der Prozesskammern (4) transportiert, und
e) nach dem Beschichtungsprozess wird die Substratplatte (9) mittels einer Transferkammer (5), einer Pufferkammer (6) und einer Schleusenkammer (7) zum Ausgang der Vakuum-Beschichtungsanlage befördert.

5. Verfahren nach Anspruch 4, **dadurch gekennzeichnet,**
**dass** Sensoren (19) zur Kontrolle der von der Einrichtung (16) zu Längsverschiebung der Strömungsblenden (12) und/oder der Einrichtung (17) zur Höhenverstellung der Strömungsblenden (12) vorgesehen sind.

6. Verfahren nach einem der Ansprüche 4 oder 5 **dadurch gekennzeichnet,**
**dass** zur steuerungstechnischen Kontrolle des gesamten Beschichtungsprozesses Lichtfeldsensoren (20) vorgesehen sind.

7. Computerprogramm mit einem Programmcode zur Durchführung der Verfahrensschritte nach einem der Ansprüche 4 bis 6, wenn das Programm in einem Computer ausgeführt wird.

8. Maschinenlesbarer Träger mit dem Programmcode eines Computerprogramms zur Durchführung des Verfahrens nach einem der Ansprüche 4 bis 6, wenn das Programm in einem Computer ausgeführt wird.

## Claims

1. Device for coating extra-long planar substrates in a vacuum coating system, said device having the following features:
a) a sequence of chambers disposed on the entry side that are to be passed through by the respective substrate plate (9), specifically a lock chamber (1), a buffer chamber (2), and a transfer chamber (3), wherein each of these chambers at the entry side is closable in an air-tight manner by means of a flap valve (8, 11, 15), and wherein the transfer chamber (3) is followed by a region of process chambers (4), and the process chambers (4) are followed by an exit-side sequence of a transfer chamber (5), a buffer chamber (7) and a lock chamber (8);
b) a transport device (10) constructed on rollers;
c) a single high-output vacuum pump (13) having an adapter flange (14) in the region of the buffer chamber (2);
d) at least one flow baffle (12) in the region of the buffer chamber (2);
e) an installation (16) for the longitudinal displacement of the flow baffles (12), wherein a sheet metal face which is designed so as to be horizontally displaceable in a further sheet metal pocket that bears tightly on the former serves as the mechanism,
f) an installation (17) for the height adjustment of the flow baffles (12); and
f) an assembly for controlling the movement procedures.

2. Device according to Claim 1, **characterized in that** sensors (19) are provided for monitoring the installation (16) for the longitudinal displacement of the flow baffles (12) and/or the installation (17) for the height adjustment of the flow baffles (12) .

3. Device according to Claim 1 or 2, **characterized in that** light field sensors (20) are provided for the control-technological management of the entire coating process.

4. Method for coating extra-long planar substrates in a vacuum coating system, comprising the following method steps:
a) after opening an entry-side flap valve (8) of an entry-side lock chamber (1), the substrate plate (9) to be coated is transported by means of a transport device (10) into the lock chamber (1), wherein in the case of an extra-long substrate plate (9) the entry-side flap valve (11) of a buffer chamber (2) which follows the lock chamber (1) is simultaneously open, and wherein the entry-side flap valve (15) of a following transfer chamber (3) is closed;
b) after the substrate plate (9) has passed the region of the flap valve (8) the flap valve (8) is closed;
c) thereafter a longitudinal displacement and a height adjustment of the installed flow baffles (12) are performed by means of an installation (16), wherein a sheet metal face which is designed so as to be horizontally displaceable in a further sheet metal pocket that bears tightly on the former serves as the mechanism, and an installation (17), so as to depend on the dimensions of the substrate plate (9) in terms of the length and thickness of the latter;
d) after the operation of a high-output vacuum pump (13) the substrate plate (9) is transported into the region of the process chambers (4); and
e) after the coating process the substrate plate (9) by means of a transfer chamber (5), a buffer chamber (6), and a lock chamber (7) is conveyed to the exit of the vacuum coating system.

5. Method according to Claim 4, **characterized in that** sensors (19) are provided for monitoring the installation (16) for the longitudinal displacement of the flow baffles (12) and/or the installation (17) for the height adjustment of the flow baffles (12) .

6. Method according to either of Claims 4 and 5, **characterized**
**in that** light field sensors (20) are provided for the control-technological management of the entire coating process.

7. Computer software program having a program code for carrying out the method steps according to one of Claims 4 to 6 when the software program is executed in a computer.

8. Machine-readable carrier having the program code of a computer software program for carrying out the method according to one of Claims 4 to 6 when the software program is executed in a computer.

## Revendications

1. Dispositif pour le revêtement de substrats plats de longueur excessive dans une installation de revêtement sous vide, présentant les caractéristiques suivantes :
a) une connexion en série de chambres agencées côté entrée, devant être traversées par la plaque de substrat respective (9), à savoir une chambre de sas (1), une chambre tampon (2) et une chambre de transfert (3), chacune de ces chambres pouvant être fermée de manière étanche à l'air côté entrée au moyen d'une soupape à clapet (8, 11, 15) et la chambre de transfert (3) étant suivie par une zone de chambres de processus (4) et les chambres de processus (4) étant suivies par une connexion en série côté sortie d'une chambre de transfert (5), d'une chambre tampon (7) et d'une chambre de sas (8),
b) un dispositif de transport (10) monté sur roulettes,
c) une seule pompe à vide à haut rendement (13) munie d'une bride d'adaptation (14) dans la zone de la chambre tampon (2),
d) au moins un diaphragme d'écoulement (12) dans la zone de la chambre tampon (2),
e) un appareil (16) pour le déplacement longitudinal des diaphragmes d'écoulement (12), une surface de tôle servant de mécanisme, qui est conçue pour pouvoir être déplacée horizontalement dans une autre poche de tôle étroitement ajustée,
f) un appareil (17) pour le réglage en hauteur des diaphragmes d'écoulement (12), et
f) un agencement pour la commande des processus de déplacement.

2. Dispositif selon la revendication 1, **caractérisé en ce que** des capteurs (19) sont prévus pour contrôler l'appareil (16) pour le déplacement longitudinal des diaphragmes d'écoulement (12) et/ou l'appareil (17) pour le réglage en hauteur des diaphragmes d'écoulement (12) .

3. Dispositif selon la revendication 1 ou 2, **caractérisé en ce que** des capteurs de champ lumineux (20) sont prévus pour le contrôle technique de l'ensemble du processus de revêtement.

4. Procédé de revêtement de substrats plats de longueur excessive dans une installation de revêtement sous vide, comprenant les étapes de procédé suivantes :
a) après l'ouverture d'une soupape à clapet côté entrée (8) d'une chambre de sas côté entrée (1), la plaque de substrat à revêtir (9) est transportée dans la chambre de sas (1) au moyen d'un dispositif de transport (10), la soupape à clapet côté entrée (11) d'une chambre tampon (2) suivant la chambre de sas (1) étant simultanément ouverte dans le cas d'une plaque de substrat (9) de longueur excessive, et la soupape à clapet côté entrée (15) d'une chambre de transfert (3) suivante étant fermée,
b) après que la plaque de substrat (9) a traversé la zone de la soupape à clapet (8), la soupape à clapet (8) est fermée,
c) ensuite, un déplacement longitudinal et un réglage en hauteur des diaphragmes d'écoulement (12) installés ont lieu en fonction des dimensions de la plaque de substrat (9) en ce qui concerne sa longueur et son épaisseur, au moyen d'un appareil (16), une surface de tôle servant de mécanisme, qui est conçue pour pouvoir être déplacée horizontalement dans une autre poche de tôle étroitement ajustée, et d'un appareil (17),
d) après le fonctionnement d'une pompe à vide à haut rendement (13), la plaque de substrat (9) est transportée dans la zone des chambres de processus (4), et
e) après le processus de revêtement, la plaque de substrat (9) est transportée vers la sortie de l'installation de revêtement sous vide au moyen d'une chambre de transfert (5), d'une chambre tampon (6) et d'une chambre de sas (7).

5. Procédé selon la revendication 4, **caractérisé en ce que** des capteurs (19) sont prévus pour contrôler l'appareil (16) pour le déplacement longitudinal des diaphragmes d'écoulement (12) et/ou l'appareil (17) pour le réglage en hauteur des diaphragmes d'écoulement (12) .

6. Procédé selon l'une quelconque des revendications 4 ou 5, **caractérisé en ce que** des capteurs de champ lumineux (20) sont prévus pour le contrôle technique de l'ensemble du processus de revêtement.

7. Programme d'ordinateur comprenant un code de programme pour réaliser les étapes de procédé selon l'une quelconque des revendications 4 à 6 lorsque le programme est exécuté dans un ordinateur.

8. Support lisible par machine comprenant le code de programme d'un programme d'ordinateur pour réaliser le procédé selon l'une quelconque des revendications 4 à 6 lorsque le programme est exécuté dans un ordinateur.
